# EUROPÄISCHE PATENTANMELDUNG

(11) **EP 2 117 122 A1**
(43) Veröffentlichungstag der Anmeldung: **11.11.2009**
(21) Anmeldenummer: 08008722.4
(22) Anmeldetag: 09.05.2008
(51) Int. Cl.: H03K 17/96

(54) **Anordnung und Verfahren zur haptischen und/oder akustischen Rückmeldung an sensorischen Bedienfeldern**

(71) Anmelder: Areus Engineering GmbH, 71083 Herrenberg (DE)
(72) Erfinder: Kraus, Oliver, Dipl. Ing., 71083 Herrenberg (DE); Apuzzo, Filippo, Dipl. Ing., 71063 Sindelfingen (DE)
(74) Vertreter: Klocke, Peter

(57) **Zusammenfassung**

Anordnung und Verfahren zur haptischen und/oder akustischen Rückmeldung von sensorischen Bedienfeldern in einer Trägerplatte, wobei zur Übertragung der haptischen Schwingungen und der akustischen Schwingungen als breitbandigen Schwingungswandler bevorzugt eine Schwingspule verwendet wird. Dadurch ist es möglich, entweder nur eine haptische oder nur eine akustische Rückmeldung oder eine Kombination aus beiden zu realisieren. Durch die Ausgabe beliebiger Frequenzen mittels der Schwingspule können auch beliebige Signale je nach Wunsch bei der Rückmeldung realisiert werden. Mittels dieser Technik ist es möglich, für eine Vielzahl von Anwendungsfällen glatte Oberflächen ohne Ritzen und Schlitze vorzusehen, auf denen sensorische Bedienfelder, die auch rau oder strukturiert sein können, angeordnet sind und bei denen mittels haptischer und/oder akustischer Rückmeldung dem Bediener eindeutig die erfolgreiche oder auch nicht erfolgreiche Betätigung signalisiert wird.

## Beschreibung

Die vorliegende Erfindung betrifft eine Anordnung und ein Verfahren zur Rückmeldung der Betätigung an sensorischen Bedienfeldern in einer diese aufnehmenden Trägerplatte. Sie betrifft außerdem die Verwendung eines besonderen Signalwandlers zur haptischen und/oder akustischen Rückmeldung.

Es ist bekannt, Bedienfelder für Schaltvorgänge in einer Trägerplatte anzuordnen, so dass dieses Bedienfeld im Wesentlichen mit der Trägerplatte eine ebene Oberfläche bildet. Im Nachfolgenden wird allgemein der Begriff Bedienfeld verwendet, wobei dieses einen oder mehrere Taster und/oder Schalter umfassen kann. Die Trägerplatte kann beispielsweise auch als eine Bedienkonsole oder Armaturenbrett in einem Fahrzeug, als Frontplatte in einem Automaten oder anders entsprechend der jeweiligen Anwendung ausgebildet sein.

Bedienelemente, wie Taster und Schalter ohne lange Schaltwege lassen sich besser in Bedienkonsolen jeglicher Art integrieren als mechanische Bedienelemente. Durch den Wegfall typischer Spalten und Ritzen zwischen einer Trägerplatte und dem Bedienelement ergibt sich ein einheitliches harmonisches Gesamtbild. Dies schließt nicht aus, dass auch strukturiert Oberflächen oder raue Oberflächen, in denen die sensorischen Bedienelemente integriert sind, verwendet werden. Im Nachfolgenden beziehen sich daher die Begriffe glatte oder ebene Oberflächen nur auf eine Oberfläche ohne Spalten und Ritzen. Des Weiteren sind sensorische Bedienelemente verschleißfrei und somit langlebiger als klassische Schalter.

Sofern mehrere direkt nebeneinander angeordnete Bedienfelder vorgesehen sind, sind je nach erlaubten Betätigungsmöglichkeiten jedem Bedienfeld oder mehreren Bedienfeldern gemeinsam ein entsprechender Sensor zugeordnet, der die Berührung des Bedienfeldes in ein elektrisches Signal umwandelt. Der Sensor befindet sich direkt hinter der Oberfläche, um die Berührung auf die Oberfläche aufzunehmen und in ein elektrisches Signal umzuwandeln. Dieses elektrische Signal löst in üblicher und bekannter Art und Weise zumindest den gewünschten Vorgang aus.

Bei diesen sensorischen Bedienfeldern kommen insbesondere kapazitive Sensoren oder piezoelektrische Elemente zum Einsatz. Insbesondere die piezoelektrischen Elemente, die auf Druck reagieren, erlauben die Auswertung des Druckes. Damit kann die Einstellung eines Druckpunktes für den Bediener Elektronisch realisiert werden, damit dieser wie bei einem herkömmlichen mechanischen Schalter erkennen kann, ob eine Betätigung erfolgt ist oder nicht. Bei kapazitiven Sensoren ist die Auswertung dieser Signale aufgrund der von der Fingergröße des Bedieners abhängigen Kapazitätsänderung schwieriger, jedoch kann grundsätzlich auch bei einer Berührung für eine gewisse Zeit ein entsprechender Impuls ausgelöst werden.

Damit der Bediener erkennen kann, wann ein Schaltvorgang erfolgt ist, kann dies grundsätzlich durch ein optisches, akustisches oder auch mechanisches Signal erfolgen. Von Vorteil ist es, dem Bediener das gewohnte Schalterlebnis zu vermitteln, das beim Drücken eines üblichen klassischen Schalters auftritt. Hierzu ist es bekannt - obwohl eine akustische Information dazu benutzt werden könnte, den Schaltvorgang zu signalisieren - eine taktile Rückmeldung an den Benutzer zu liefern. Eine optische Rückmeldung kann mitunter deshalb nachteilig sein, weil es für den Bediener notwendig ist, die Anzeige betrachten zu müssen.

Für die taktile Rückmeldung ist es bekannt, haptische Techniken zu verwenden. Der Begriff "Haptik" ist bei Wissenschaftlern auf dem Gebiet der menschlichen Psychophysik üblich, die untersuchen, wie Menschen ihre Hände und Finger einsetzen, um Objekte zu spüren und zu manipulieren. Hier gibt es den Begriff "haptische Benutzerschnittstellen", womit Geräte beschrieben werden, mit denen die Bewegung der Hände gemessen und das Empfindungsvermögen in den Händen stimuliert werden können. Derartige haptische Benutzerschnittstellen bieten den großen Vorteil, dass ein Benutzer zu der gleichen Zeit während er das Eingabegerät betätigt, gewisse taktile oder kinetische Rückmeldungen erhält. Dieses Gefühl ermöglicht es, eine intuitive Verbindung zwischen der Betätigung des Bedienelemtes und den dadurch induzierten Aktionen zu schaffen. Darüber hinaus kann eine derartige Rückmeldung die vorstehend erwähnte notwendige Information liefern, in der ein Benutzer über den aktuellen Zustand oder den Modus des Bedienelementes informiert wird, ohne die Anzeige betrachten zu müssen.

Für die Rückmeldung insbesondere bei Bedienkonsolen in Fahrzeugen wurden bereits Hubmagnete mit einem Stößel eingesetzt, der auf der Rückseite der Bedienkonsole montiert einen an dem Bedienelement fühlbaren Impuls, der über die Bedienkonsole übertragen wird, erzeugt. Derartige Hubmagnete bewirken einen Stoß mit allen Frequenzen, so dass neben dem fühlbaren Impuls an dem Bedienelement zusätzlich metallische Klanggeräusche entstehen. Des weiteren haben diese Hubmagnete mit Stößel eine teilweise unerwünschte Bauhöhe und lassen in manchen Anwendungsbereichen eine haptische Rückmeldung mit sinnvollem räumlichen Aufwand nicht zu.

Der vorliegenden Erfindung liegt die Aufgabe zugrunde eine verbesserte Anordnung und ein Verfahren zur Rückmeldung der Betätigung an sensorischen Bedienfeldern vorzuschlagen, die insbesondere eine Auswahl des Herstellers in der Art der Rückmeldung bei Bedarf geräuscharm mit geringem Platzbedarf (Einbautiefe) ermöglichen.

Diese Aufgabe wird erfindungsgemäß durch eine Anordnung gemäß des Anspruchs 1 sowie durch ein Verfahren gemäß Anspruch 9 und die Anwendung gemäß Anspruch 15 gelöst. Weitere vorteilhafte Ausgestaltungen sind den jeweiligen diesbezüglich rückbezogenen Unteransprüchen zu entnehmen.

Gemäß der Erfindung ist in bekannter Art und Weise mindestens ein Bedienfeld in einer Trägerplatte mit einem an dem Bedienfeld angeordneten Sensor zur Bildung eines sensorischen Bedienfeldes vorgesehen. Bei dem Sensor kann es sich sowohl um einen kapazitiven als auch um einen piezoelektrischen Sensor handeln, wobei jedoch der piezoelektrische Sensor bevorzugt ist. Für die Erzeugung des Rückmeldesignals zu dem Bediener ist mindestens ein breitbandiger elektromechanischer und/oder elektroakustischer Signalwandler, vorzugsweise eine Schwirigspule, der mindestens einem Bedienfeld zugeordnet ist, vorgesehen. Ein breitbandiger Signalwandler ermöglicht die Übertragung von Signalen über einen großen Frequenzbereich. Vorzugsweise kann dazu eine Schwingspule eingesetzt werden. Derartige Schwingspulen sind als Antriebseinheit eines elektrodynamischen Schallwandlers, wie beispielsweise Lautsprecher, bekannt. Üblicherweise bestehen sie aus einem dünnen Draht, der auf dem sogenannten Schwingspulenträger aufgewickelt ist. Diese Spule taucht in den Luftspalt eines Permanentmagneten ein, indem sich ein starkes Magnetfeld befindet. Das sich durch eine stromflussaufbauende magnetische Wechselfeld bewegt die Schwingspule mit der Membran nach vorne und hinten und ermöglicht es so, bei einem Lautsprecher die Spannungsschwingungen in Luftschwingungen umzusetzen. Derartige Schwingspulen sind auch unter dem Begriff Exciter für die Übertragung von Schallschwingungen (Lautsprecher) bekannt.

Überraschender Weise wurde festgestellt, dass derartige für akustische Zwecke vorgesehene Schwingspulen auf eine Trägerplatte montiert auch dazu verwendet werden können, mechanische Schwingungen zu übertragen. Wichtig ist dabei, dass die Masse der Schwingspule in einem entsprechenden Verhältnis zu der Masse der Trägerplatte steht, damit überhaupt spürbar die gewünschten Schwingungen übertragen werden können. Dies kann entweder durch eine entsprechende Ausgestaltung der Schwingspule oder durch geeignete Abstützung der Schwingspule auf der Rückseite erreicht werden. Grundsätzlich ist es auch möglich durch den Einsatz erhöhter elektrischer Energie bei im Verhältnis geringer Masse diesen Mangel zu kompensieren, wobei diese Betriebsweise an sich nicht vorteilhaft ist. Die Anordnung umfasst außerdem eine Steuereinheit, die mindestens mit einem Sensor und einem Signalwandler elektrisch verbunden ist, zur Auswertung der von dem Sensor abgegebenen Steuersignale und Erzeugung mindestens eines haptischen und/oder akustischen Rückmeldesignals.

Durch die Verwendung einer Schwingspule als elektromechanischer und/oder elektroakustischer Signalwandler ist es somit möglich, mit diesem Signalwandler entweder ein haptisches oder ein akustisches Rückmeldesignal oder sogar gleichzeitig ein haptisches und akustisches Rückmeldesignal zu erzeugen. Der Einsatz einer derartigen Schwingspule erlaubt dadurch eine Vielzahl von verschiedenen Rückmeldesignalen, die entsprechend den Wünschen des Herstellers oder des Benutzers vorgesehen werden können. Darüber hinaus sind derartige Schwingspulen zuverlässig und langlebig sowie kostengünstig erhältlich.

Die akustischen Signale können auf das haptische Signal aufmoduliert werden, wenn gleichzeitig ein haptisches und akustisches Rückmeldesignal abgegeben werden soll. Das Signal, bei dem dem haptischen Signal ein akustisches Signal überlagert ist, wird in der Signaleinheit abgespeichert, so dass es bei jeder Betätigung ausgegeben wird. Die Polarität der Impulse für die haptische Rückmeldung spielt keine Rolle. Um die haptische Rückmeldung an einem Bedienfeld bei gleichbleibender Amplitude für den Bediener stärker oder leichter spürbar zu machen, kann das Bedienfeld in einem Frequenzbereich mit den geringsten Dämpfungswerten der Trägerplatte belegt werden oder es kann die Impulsdauer erhöht werden. Hierbei wirkt sich vorteilhaft aus, dass auf einen positiven Impuls stets ein negativer folgt und damit die Schwingspule von einer positiven mechanischen Auslenkung zu einer negativen mechanischen Auslenkung hin, ein größerer Beschleunigungsweg ermöglicht. Eine von der Intensität geringere haptische Schalterrückmeldung kann entsprechend durch eine Erregung überhalb bzw. unterhalb des Bereichs mit den geringsten Dämpfungswerten der Trägerplatte oder durch eine Verringerung der Impulsdauer bis minimal einer Halbwelle erfolgen.

Sofern die Trägerplatte einen linearen Frequenzgang aufweist, kann eine weichere haptische Rückmeldung auch durch eine Frequenzanregung eher im unteren Bereich (ca. 40 bis 100 Hz) und eine härtere Schalterrückmeldung bei einer Anregungsfrequenz eher im oberen Bereich (ca. 150 bis 200 Hz) bewirkt werden.

Erst durch den Einsatz dieses Signalwandlers ist es möglich, nahezu identische Schaltgefühle und/oder Schaltgeräusche bei der Betätigung eines sensorischen Bedienfeldes zu erzeugen, das in einer möglichst ebenen Oberfläche der Trägerplatte angeordnet ist. Einer Schwingspule erlaubt eine beliebige Signalvielfalt bei kurzer Ansprechzeit und hohen Kräften.

Gemäß einer bevorzugten Ausbildung der Erfindung weist das haptische Rückmeldesignal eine Frequenz von 30 bis 300 Hz auf, um den maximalen Empfindlichkeitsbereich einer Fingerspitze auszunutzen.

Nach einer weiteren bevorzugten Ausbildung der Anordnung beträgt die Signaldauer für das haptische Rückmeldesignal maximal 60 ms, wenn es sich um ein korrektes Betätigungssignal als Bedienungssignal und mehr als 60 ms, wenn es sich um fehlerhaftes Betätigungssignal als Fehlbedienungssignal handelt. Es wurde festgestellt, dass die Signaldauer für ein Bestätigungssignal in dem vorgegebenen Bereich durch die taktile Wahrnehmung eindeutig identifizierbar ist, während bei einer längeren Signaldauer als 60 ms Vibrationen wahrnehmbar sind. Gemäß der Erfindung wird dies ausgenutzt, um damit haptisch eine vibrierende Rückmeldung bei Fehlbedienung zu erzeugen. Unabhängig davon kann gleichzeitig sowohl bei der ordnungsgemäßen Bedienung als auch bei der Fehlbedienung über die Schwingspule ein akustisches Signal ausgegeben werden.

Gemäß einer besonders bevorzugten Ausbildung der Erfindung wird ein sinusförmiges Signal verwendet, da herausgefunden wurde, dass ein derartiges Signal der beste Kompromiss zwischen einer guten Haptik und einer geringen Akustik bei der Rückmeldung gewährleistet. Zur Vermeidung von störenden akustischen Anteilen bei kurzen Signalformen, die durch plötzliche Änderungen des Signalverlaufs, wie sie am Anfang und am Ende des Signals entstehen, verursacht werden, wird ein haptisches sinusförmiges Rückmeldesignal verwendet, das einer Signalform entspricht, die sich ergibt, wenn ein Signal mittels eines Tiefpasses mit einer Grenzfrequenz von 20 bis 200 Hz, vorzugsweise 50 bis 100 Hz, gefiltert wird. Die Erzeugung eines derart definierten Signals kann entweder wie definiert oder, wie heute eher üblich, durch entsprechende handelsübliche Software erfolgen, die auch eine Bearbeitung des Signals ermöglicht. Hierbei werden durch Aufblendung und Abblendung (Fading) des reinen Sinussignals die Anfangs- und Endsteigungen abgerundet, um die Steigung dU/dt zu verringern. Die Steigung ist abhängig vom elektrischen Widerstandswert der Spule, d.h. bei kleineren Widerstandswerten ist ein stärkeres Fading als bei höheren Widerstandswerten bei gleicher Leistung vorteilhaft, um geräuscharm zu bleiben.

Erfindungsgemäß weist die Steuereinheit eine Auswerteeinheit und eine Signaleinheit auf, wobei die Auswerteeinheit das Sensorsignal auswertet und ein definiertes Steuersignal für die Signaleinheit erzeugt. Die dafür benötigte Technik ist handelsüblich erhältlich. Das Steuersignal bildet ein Triggersignal für die Signaleinheit basierend auf dem von dem Bediener ausgeübten Druck auf den bevorzugten piezoelektrischen Sensor. Bei der Verwendung eines kapazitiven Sensors kann die Dauer der Berührung als Sensorsignal verwendet werden, um die Erfindung in gleicher Weise zu realisieren.

Gemäß einer weiteren vorteilhaften Ausbildung der Erfindung weist die Signaleinheit einen Prozessor mit Speicher auf, wobei in dem Speicher unterschiedliche Signalformen als Mustersignale für das haptische und/oder akustische Rückmeldesignal abgespeichert oder abspeicherbar sind. Je nach Wunsch des Anwenders oder den Bedürfnissen des Bedieners können in dem Speicher beliebige akustische Signale abgespeichert werden. Darüber hinaus ist das optimale bevorzugte haptische Rückmeldesignal als solches abgespeichert. Akustische und/oder haptische Rückmeldesignale für das Drücken und/oder Loslassen des Bedienfeldes mit entsprechender ausgewählter Amplitude und Signaldauer können in dem Speicher abgespeichert sein. Sofern nur beim Drücken oder Loslassen ein Signal abgegebenen wird, handelt es sich um ein einfaches Signal, sofern sowohl beim Drücken als auch beim Loslassen ein Rückmeldesignal ausgegebenen wird, sind Signalpaare abgespeichert.

Hier zeigt sich der besondere Vorteil der Verwendung eines breitbandigen Signalwandlers, wie einer Schwingspule, da alle möglichen Anwendungsfälle und Signalformen, insbesondere auch für die akustische Wiedergabe, da diese nicht an taktile Bedingungen geknüpft sind, abgespeichert werden können. So können besondere Schaltgeräusche, wie sie bei einem herkömmlichen mechanischen Schalter auftreten, genauso erzeugt werden, wie Melodien oder andere vorstellbare Tonfolgen. Um eine spürbare haptische Rückmeldung zu erreichen, ist es vorteilhaft, das Verhältnis der Masse der Schwingspule zu der Masse der die sensorischen Bedienfelder aufnehmenden Trägerplatte kleiner oder gleich 1 zu halten. Andernfalls kann nur ein gewünschter Effekt durch erhöhte elektrische Leistung erreicht werden.

Weitere Merkmale der Erfindung ergeben sich aus der folgenden Beschreibung eines Ausführungsbeispiels in Verbindung mit den Ansprüchen und den Zeichnungen. Die einzelnen Merkmalen können je für sich oder zu mehreren bei Ausführungsformen der Erfindung verwirklicht sein. Es stellen dar:
- Figur 1: eine Prinzipskizze der Anordnung;
- Figur 2: Blockschaltbild der Signaleinheit;
- Figur 3: prinzipielle Verläufe von haptischen Impulsen
- Figur 4: prinzipieller Verlauf eines haptischen Impulses mit überlagertem akustischem Impuls
- Figur 5: prinzipielle Verläufe haptischen Signalen mit verschiedenen Glättungen.

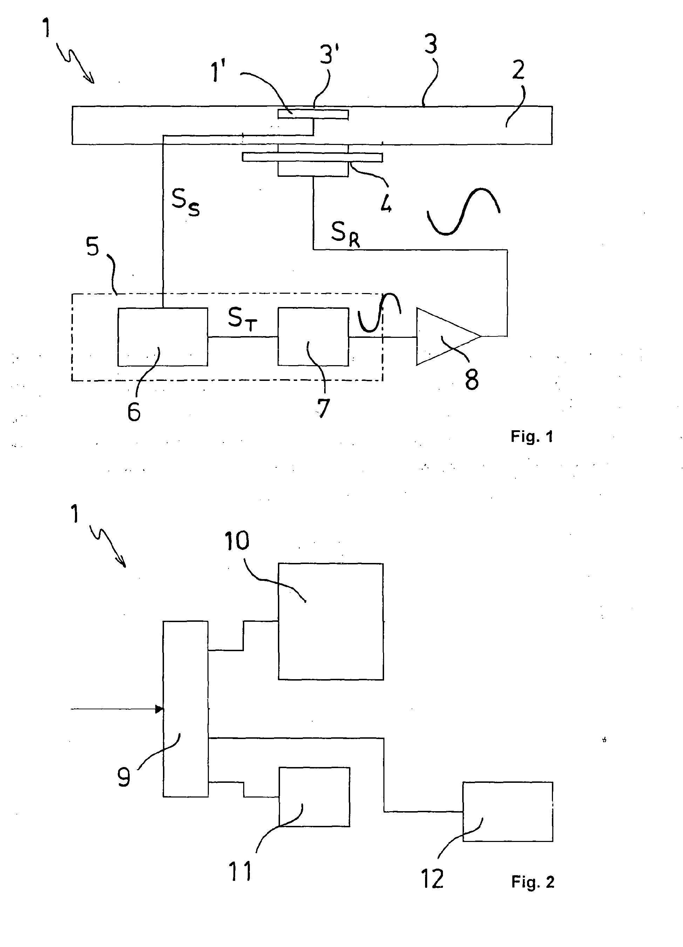

Figur 1 zeigt das prinzipielle Blockschaltbild einer Anordnung zur Rückmeldung der Betätigung an einem sensorischen Bedienfeld. Sie zeigt eine Trägerplatte 2 mit einem Sensor 1', der so in der Trägerplatte 2 angeordnet ist, dass die Bedienoberfläche 3 der Trägerplatte 2 zusammen mit dem vor dem Sensor 1' befindlichen Bedienfeld 3' eben ist. Die Oberfläche selbst kann, wie eingngs erwähnt, auch beispielsweise strukturiert oder rau sein. Das Bedienfeld 3' und der Sensor 1' werden nachfolgend auch gemeinsam als sensorisches Bedienfeld 1 bezeichnet, wobei, wie schon erwähnt, nicht jedem Bedienfeld 3' ein Sensor 1' zugeordnet sein muss. Hier kann es sich auch um eine Gruppe von Bedienfeldern 3' handeln, die definitionsgemäß auch als Bedienfeld bezeichnet werden. Die Trägerplatte 2 steht symbolhaft auch für einen Ausschnitt aus einer größeren Bedienkonsole oder einer größeren Bedienerplatte mit mehreren entweder nebeneinander oder entfernt voneinander angeordneten Bedienfeldern in der Trägerplatte 2. Der Sensor 1' ist in dem Ausführungsbeispiel als piezoelektrischer Sensor ausgebildet. Dieser überträgt bei Betätigung ein Sensorsignal S_{S} zu einer Steuereinheit 5, die eine Auswerteeinheit 6 und eine Signaleinheit 7 aufweist. Das Sensorsignal S_{S} wird von der Auswerteeinheit 6 in ein Triggersignal S_{T} für die Signaleinheit 7 umgewandelt. Die Signaleinheit 7 gibt ein Rückmeldesignal S_{R} ab, das nach der Verstärkung durch einen Verstärker 8 zu einem auf der Rückseite der Trägerplatte 2 angeordneten Schwingungswandler 4 geführt wird. In der Figur ist der Schwingungswandler 4 direkt gegenüber dem Sensor 1 an der Trägerplatte 2 angeordnet. Dies muss grundsätzlich nicht so sein, da beispielsweise bei mehreren nebeneinander angeordneten sensorischen Bedienfeldern 1, von denen nicht mehrere gleichzeitig betätigt werden können, auch nur ein Schwingungswandler 4 vorgesehen werden kann. Der Schwingungswandler 4 überträgt die Schwingungen über die Trägerplatte 2 zu allen Bedienfeldern 3', da der Bediener jedoch nur ein sensorisches Bedienfeld 1 betätigen darf und kann, erfährt er taktil an diesem einen sensorischen Bedienfeld 1 die Rückmeldung. Genauso ist es möglich, mehrere voneinander entfernt angeordnete sensorische Bedienfelder 1 auch mit nur einem Schwingungswandler 4 zu bedienen, sofern hier auch gilt, dass nur ein sensorisches Bedienfeld 1 von dem Bediener betätigt wird. Die Übertragung der haptischen Rückmeldeschwingung durch die Trägerplatte 2 erfolgt hier entsprechend. Dabei wird jedoch der Schwingungswandler 4 so zu dem entfernt voneinander angeordneten Bedienfeldern 3' angebracht, dass die Rückmeldesignale, die der Bediener taktil an dem sensorischen Bedienfeld 1 erfährt, in der Intensität gleich sind.

Gemäß der Erfindung wird als Schwingungswandler 4 eine Schwingspule verwendet, die als Exciter in der Akustik bekannt und im Handel erhältlich ist. Wie bereits erwähnt ermöglicht diese Schwingspule die Ausgabe sowohl von optischen als auch akustischen Rückmeldesignalen sowie die Kombination der Signale. Hierzu ist die Signaleinheit 7 vorgesehen, die in der Figur 2 in einem Blockschaltbild näher ausgeführt ist. Die Signaleinheit 7 weist einen Prozessor 9 auf, der mit einem oder mehreren Speicher 10 verbunden ist. In diesen Speicher 10 werden die für die haptische Rückmeldung vorgesehenen Signale abgespeichert, die gewünscht werden. Zur Auswahl der entsprechenden Signale ist ein zusätzliches Ein-/Ausgabemodul 11 vorgesehen. Je nach Auswahl werden die gewünschten Signale direkt von dem Prozessor 9 zu Ausgangsfiltern 12 (Tiefpass) übertragen. Die Grenzfrequenz der einzelnen Tiefpässe (je nach Anwendung) ist entsprechend den gewünschten zu übertragenden Frequenzen eingestellt, so dass auch eine Stereoübertragung (mit zwei Tiefpässen und entsprechenden Signalwandler) als akustisches Rückmeldesignal S_{R} möglich ist.

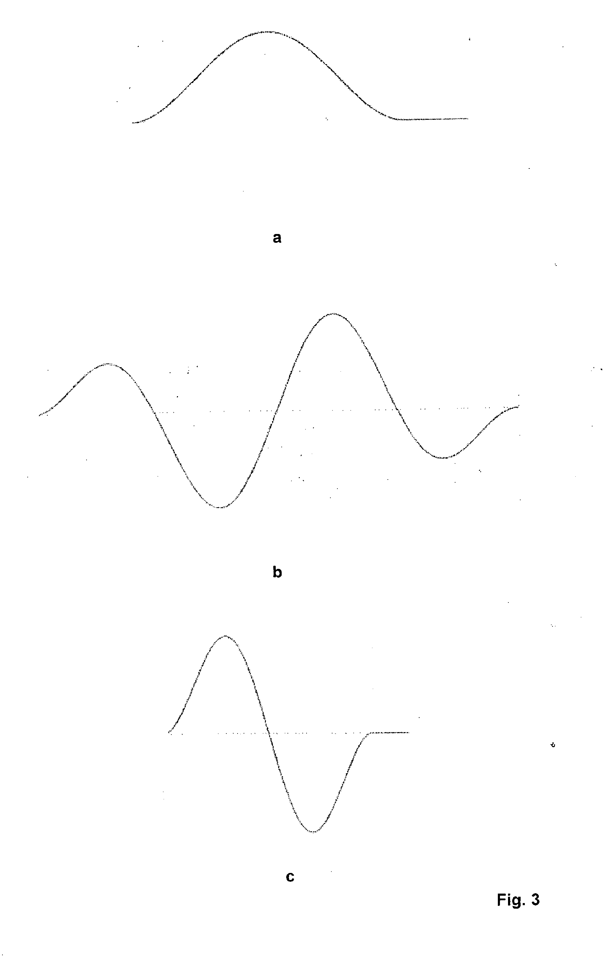

In Figur 3 ist beispielhaft der Verlauf eines haptischen Rückmeldesignals dargestellt, das keine ungewünschten akustischen Nebengeräusche erzeugt. Der Verlauf dieses sinusförmigen Rückmeldesignals entspricht einem Verlauf, wie er sich durch die Filterung mit einem Tiefpass und einer Grenzfrequenz zwischen 20 und 200 Hz ergibt. Die Figur zeigt verschiedene haptische Rückmeldesignale bei 60 (Figur a), 77 (Figur b)und 90 Hz (Figur c). Solange die Gesamtdauer von 60 ms nicht überschritten wird, kann das Signal, wie bei 77 und 90 Hz gezeigt, auch mehrere Impulse aufweisen.

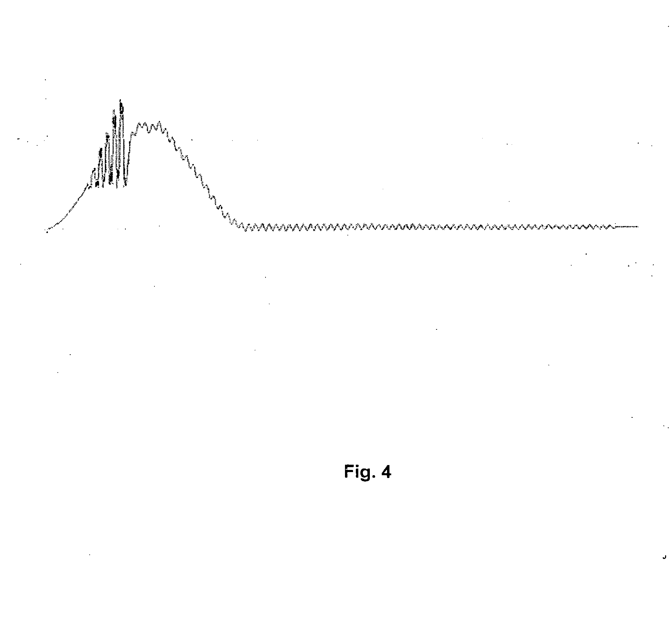

Figur 4 zeigt noch ein haptisches Rückmeldesignal bei 70 Hz, das mit einer Tonfrequenz überlagert ist, so dass gleichzeitig mit der haptischen Rückmeldung auch ein akustisches Signal ausgegeben wird. Das akustische Signal kann dabei beispielsweise ein Schaltgeräusch oder auch jede beliebige andere Tonfolge sein.

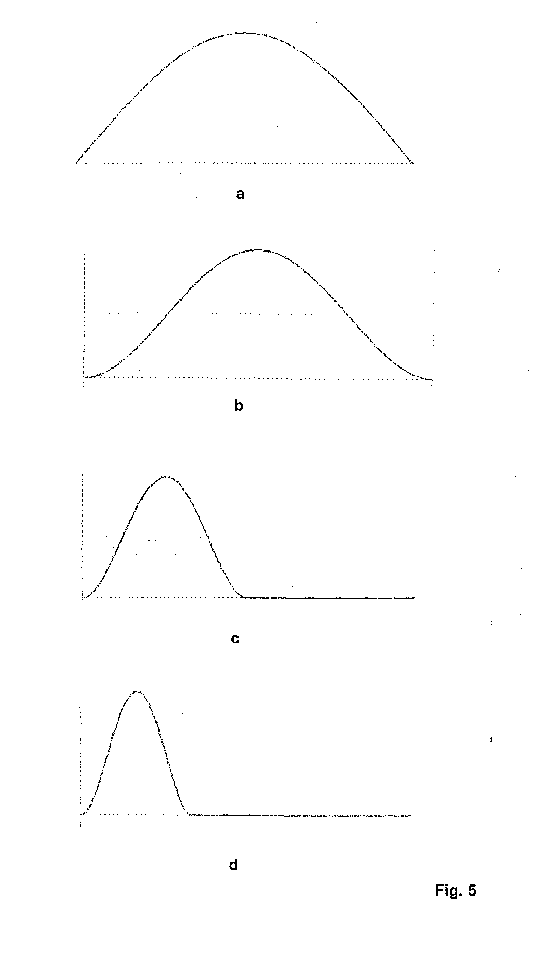

Figur 5 zeigt schließlich noch beispielhaft den Signalverlauf eines ungeglätteten 50 Hz Sinussignals (Figur a), eines geglätteten 50 Hz Sinussignals (Figur b), eines geglätteten 100 Hz Sinussignals (Figur c) und eines geglätteten 150 Hz Sinussignals (Figur d), mit abgerundeten Anfangs- und Endsteigungen, wie sie durch Fading des Sinussignals erreicht werden.

## Patentansprüche

1. Anordnung zur Rückmeldung der Betätigung an sensorischen Bedienfeldern mit
mindestens einem Bedienfeld (3') in einer Trägerplatte (2); einen an dem Bedienfeld (3') angeordneten Sensor (1') zur Bildung eines sensorischen Bedienfeldes (1);
mindestens einem breitbandigen elektromechanischen und/oder elektroakustischen Signalwandler, vorzugsweise einer Schwingspule (4), die mindestens einem sensorischen Bedienfeld (1) zugeordnet ist, und
einer Steuereinheit (5), die mindestens mit einem Sensor (1') und der Schwingspule (4) elektrisch verbunden ist, zur Auswertung der von dem Sensor (1') abgegebenen Sensorsignale (S_{S}) und Erzeugung mindestens eines haptischen und/oder akustischen Rückmeldesignals (S_{R}).

2. Anordnung nach Anspruch 1, **dadurch gekennzeichnet, dass** das haptische Rückmeldesignal (R_{S}) eine Frequenz von 30 bis 300 Hz aufweist.

3. Anordnung nach Anspruch 1 oder 2, **dadurch gekennzeichnet, dass** für das haptische Rückmeldesignal (S_{R}) die Signaldauer maximal 60 ms beträgt, wenn es sich um korrektes Betätigungssignal und die Signaldauer mehr als 60 ms beträgt, wenn es sich um ein fehlerhaftes Betätigungssignal handelt.

4. Anordnung nach einem der vorangegangenen Ansprüche, **dadurch gekennzeichnet, dass** das haptische Rückmeldesignal (S_{R}) ein sinusförmiges Signal ist, das einem Signal entspricht, das mittels eines Tiefpasses mit einer Grenzfrequenz von 20 bis 200 Hz, vorzugsweise 50 bis 100 Hz, gefiltert wurde.

5. Anordnung nach einem der vorangegangenen Ansprüche, **dadurch gekennzeichnet, dass** die Steuereinheit (5) eine Auswerteinheit (6) und eine Signaleinheit (7) umfasst, wobei die Auswerteeinheit (6) das Sensorsignal (S_{S}) auswertet und ein Steuersignal (S_{T}) für die Signaleinheit (7) erzeugt.

6. Anordnung nach Anspruch 5, **dadurch gekennzeichnet, dass** die Signaleinheit (7) einen Prozessor (9) mit Speicher (10) aufweist und in dem Speicher (10) Signalformen für das haptische und/oder akustische Rückmeldesignal (S_{R}) abgespeichert/abspeicherbar sind.

7. Anordnung nach Anspruch 5 oder 6, **dadurch gekennzeichnet, dass** die Signaleinheit (7) in Abhängigkeit von dem Steuersignal (S_{T}) haptische und/oder akustisches Rückmeldesignale (S_{R}) mit vorgebbaren Parametern, wie Signaldauer, Amplitude, Anzahl der Impulse, ausgibt.

8. Anordnung nach einem der vorangegangenen Ansprüche**, dadurch gekennzeichnet, dass** das Verhältnis der Masse der Schwingspule (4) zu der Masse, der die sensorischen Bedienfelder (1) aufnehmenden Trägerplatte (2) kleiner oder gleich 1 ist.

9. Verfahren zur Rückmeldung der Betätigung von sensorischen Bedienfeldern (1) in eine Trägerplatte (2) mit
Auswertung einer Druckbetätigung eines Bedieners mindestens eines sensorischen Bedienfeldes (1);
Erzeugen eines definierten Schaltsignals (S_{T}) als Triggersignal für ein Rückmeldesignal (S_{R}) zu dem mindestens einen sensorischen Bedienfeld (1), **gekennzeichnet durch**
haptische und/oder akustische Anregung einer dem sensorischen Bedienfeld (1) zugeordneten breitbandigen elektromechanischen und/oder elektroakustischen Signalwandler, vorzugsweise einer Schwingspule (4), mit einem oder mehreren Rückmeldesignalen (S_{R}).

10. Verfahren nach Anspruch 9, **dadurch gekennzeichnet, dass** als Rückmeldesignal (S_{R}) ein in einem Speicher (10) abgelegtes Mustersignal verwendet wird.

11. Verfahren nach Anspruch 9 oder 10, das als haptisches Rückmeldesignal (S_{R}) ein sinusförmiges Signal verwendet wird, das eine Signal entspricht, das sich durch die Filterung mittels eines Tiefpasses bei einer Grenzfrequenz von 20 bis 200 Hz, vorzugsweise 50 bis 100 Hz ergibt, vorzugsweise mit einer Signaldauer von maximal 60 ms als Bestätigung und von mehr als 60 ms Dauer bei Fehlbedienung.

12. Verfahren nach einem der vorangegangenen Ansprüche 9 bis 11, **dadurch gekennzeichnet, dass** nebeneinander und/oder entfernt voneinander angeordnete sensorische Bedienfelder (1) mit einem Signalwandler (4) haptisch angeregt werden, vorzugsweise in dem Rückmeldesignale (S_{R}) mit gleicher Amplitude angelegt werden.

13. Verfahren nach einem der vorangegangenen Ansprüche 9 bis 12, **dadurch gekennzeichnet, dass** bei einer haptischen und akustischen Anregung des Signalwandlers (4) ein Rückmeldesignal (S_{R}) erzeugt wird, bei dem einem haptischen Signal ein akustisches Signal überlagert ist.

14. Verfahren nach einem der vorangegangenen Ansprüche 9 bis 13, **dadurch gekennzeichnet, dass** der Signalwandler (4) die haptische und/oder akustische Rückmeldung beim Betätigen und/oder Loslassen des jeweiligen sensorischen Bedienfeldes (1) mit Rückmeldesignalen (S_{R}) beaufschlagt wird.

15. Verwendung einer Schwingspule (4) als elektromechanischen und/oder elektroakustischen Signalwandler zur haptischen und/oder akustischen Rückmeldung der Betätigung an sensorischen Bedienfeldern (1) in einer diese aufnehmenden Trägerplatte (2).
